# EUROPEAN PATENT SPECIFICATION

(11) **EP 2 031 086 B1**
(45) Date of publication and mention of the grant of the patent: **22.09.2010**
(21) Application number: 08012109.8
(22) Date of filing: 04.07.2008
(51) Int. Cl.: C23C 14/34, C23C 14/14, C22C 5/06, G11B 7/258

(54) **Ag base alloy sputtering target and method for manufacturing the same**
Sputtern von AG-Basislegierungszielmaterial und Verfahren zur Herstellung davon
Cible de pulvérisation d'alliage à base d'Ag et son procédé de fabrication

(30) Priority: 29.08.2007 JP 2007223152
(43) Date of publication of application: 04.03.2009
(73) Proprietor: Kobelco Research Institute , Inc., Kobe-shi Hyogo 651-0073 (JP)
(72) Inventor: Takagi, Katsutoshi, Takasago-shi Hyogo 676-8670 (JP); Morimoto, Hidekazu, Takasago-shi Hyogo 676-8670 (JP); Matsuzaki, Hitoshi, Takasago-shi Hyogo 676-8670 (JP); Tauchi, Yuki, Takasago-shi Hyogo 676-8670 (JP)
(74) Representative: Müller-Boré & Partner Patentanwälte

(56) References cited:
- JP-A- 2003 027 160
- JP-A- 2004 002 929
- US-A1- 2004 238 356

## Description

The present invention relates to an Ag base alloy sputtering target containing Ta and Cu and a method for manufacturing the same, in particular, to an Ag base alloy sputtering target useful for forming an Ag base alloy reflective film for an optical information recording medium.

Since a thin film made of an Ag (Silver) alloy (Ag base alloy thin film) has excellent characteristics, such as high reflectance, low electrical resistivity, and high thermal conductivity, it is widely used in various films, for example: reflective films, semi-transmissive reflective films, and heat diffusion films for optical information recording media (optical disks) ; reflective films, reflective electrode films, and interconnection films for flat panel displays; Low-E (low-emissivity) films for heat-ray reflecting/shielding window glasses or the like; shielding films for shielding electromagnetic waves; reflective films for vehicle headlamps and lighting devices; and reflective films and reflective electrode films for optical components and light emitting diodes, or the like. In particular, an Ag base alloy thin film has sufficiently high reflectance with respect to a blue-violet laser used in a next-generation optical disk, and high thermal conductivity required of a write-once/rewritable optical disk, therefore an Ag base alloy thin film is preferably used for these applications.

An aforementioned Ag base alloy thin film is preferably formed by the sputtering process in which a sputtering target made of an Ag base alloy (Ag base alloy sputtering target) is sputtered. The sputtering process refers to a process in which, in a sputtering chamber where Ar is introduced therein after a vacuum suction, a plasma discharge is generated between a substrate and a sputtering target (hereinafter, sometimes simply referred to as a target) and atoms of the target are sputtered from the target by crashing ionized Ar generated by the plasma discharge against the target, thereby a thin film is formed by depositing the atoms of the target on the substrate. A thin film formed by the sputtering process is excellent in uniformity of composition in the direction of the film surface and film thicknesses or the like, in comparison with a thin film formed by the ion plating process, the vacuum deposition process, or the electron beam evaporation process. Further, the sputtering process has an advantage that the process can form a thin film having the same composition as that of a target material unlike the vacuum deposition process.

In order to form such a thin film of high quality, a sputtering target is required to have an element constituting the target, distributing uniformly in the direction of the sputtering surface (in the sputtering surface) without variation and segregation thereof. If a thin film is formed with the use of a target in which an element constituting the target does not distribute uniformly in the target surface, the film has an increased variation in composition and the thickness in the direction of the film surface (in film surface), therefore the film has an increased variation in characteristics, such as reflectance, causing a deteriorated performance as a reflective film.

Ag base alloy sputtering targets (Ag base alloy targets) are generally manufactured by the melting and casting process (for example, Patent Documents 1-11). On the other hand, it is recommended that a target containing a high melting point metal, such as Ta, is manufactured by the powder sintering process in which metallic powders are mixed to be subjected to the Hot Isostatic Press (HIP), without the use of the melting and casting process. Although not related to an Ag base alloy target, it is described, for example, in Patent Document 12 that a sputtering target made of a metallic material with a high melting point, such as Ta and Ru, used for manufacturing semiconductor LSIs, is most preferably manufactured by the power sintering process. In addition, a method for manufacturing a Co-Ta based target used for magnetic recording media by using the powder sintering process, is described in Patent Document 13.
[Patent Document 1] Japanese Patent Application Publication No. 3365762
[Patent Document 2] JP-A-2000-239835
[Patent Document 3] JP-A-2002-129314
[Patent Document 4] JP-A-2004-2929
[Patent Document 5] JP-A-2004-43868
[Patent Document 6] JP-A-2004-84065
[Patent Document 7] JP-A-2004-126497
[Patent Document 8] JP-A-2004-339585
[Patent Document 9] JP-A-2005-36291
[Patent Document 10] JP-A-2005-314717
[Patent Document 11] JP-A-2005-330549
[Patent Document 12] JP-A-2001-20065
[Patent Document 13] JP-A-2000-20.7725

An object of the present invention is to provide an Ag-Ta-Cu alloy sputtering target which can form a thin film excellent in uniformity of composition in the direction of the film surface (in the film surface) or the like, in a steady stable condition, and a process for manufacturing the sputtering target.

One aspect of the present invention to achieve the object resides in an Ag base alloy sputtering target which is **characterized in that**: the sputtering target is made of an Ag base alloy containing 0. 6 to 10.5 atomic % Ta and 2 to 13 atomic % Cu, and when the sputtering surface of the above sputtering target is image-analyzed,
(1) regarding Ta, the ratio of the total area of Ta particles having a circle equivalent diameter of from 10 µm or more to 50 µm or less, to the total area of all Ta particles, is 60 % or more, and the average distance between the centers of gravity of Ta particles is from 10 µm or more to 50 µm or less; and
(2) regarding Cu, the ratio of the total area of Cu particles having a circle equivalent diameter of from 10 µm or more to 50 µm or less, to the total area of all Cu particles, is 70% or more, and the average distance between the centers of gravity is from 60 µm or more to 120 µm or less.

The Ag base alloy sputtering target may preferably be used for formation of a reflective film for an optical information recording medium.

Another aspect of the present invention to achieve the object resides in a method for manufacturing the Ag base alloy sputtering target which includes: mixing a material containing Ag powder having the mean volume diameter (d50) of from 10 µm or more to 50 µm or less, Ta powder having the mean volume diameter (d50) of from 10 µm or more to 50 µm or less, and Cu powder having the mean volume diameter (d50) of from 10 µm or more to 50 µm or less, for 30 to 90 minutes to prepare for a mixed power; and carrying out the HIP processing on the mixed powder at the temperature of 500 to 600 °C for 1 to 3 hours.

According to the aspects of the present invention, Ta particles and Cu particles having a predetermined diameter are distributed uniformly at almost the same intervals and over a certain area, in the sputtering target surface (in the sputtering surface), thereby a thin film excellent in the uniformity of composition in the direction of the film surface (in the film surface), can be formed in a steady stable condition. The thus obtained thin film is extremely excellent in the reflective characteristic and the write-once and rewriting characteristic, which film can preferably be used as a reflective film for an optical information recording medium or the like.

### BRIEF DESCRIPTION OF THE DRAWINGS

Fig.1 is an optical microscopic image (magnification: 100 times) showing a metallic structure of an Ag base alloy target of sample No. 4 (example of the present invention) in example;
Fig.2 is an SEM image (magnification: 300 times) showing a metallic structure of an Ag base alloy target of the sample No. 4 (example of the present invention) in example;
Fig.3 is a characteristic X-ray image (magnification: 300 times) of EPMA area analysis showing the distribution state of Ag of an Ag base alloy target of the sample No. 4 (example of the present invention) in example;
Fig.4 is a characteristic X-ray image (magnification: 300 times) of the EPMA area analysis showing the distribution state of Ta of an Ag base alloy target of the sample No. 4 (example of the present invention) in example;
Fig.5 is a characteristic X-ray image (magnification: 300 times) of the EPMA area analysis showing the distribution state of Cu of an Ag base alloy target of the sample No.4 (example of the present invention) in example;
Fig.6 is a diagram for illustrating the concept of the distance between the centers of gravity in the present invention; and
Fig.7 is other diagram for illustrating the concept of the distance between the centers of gravity in the present invention.

The present inventor(s) has disclosed an optical information recording medium having an Ag-X-Cu alloy reflective film (wherein, X is at least one of Ti, W, Ta, V, Mo, Nb, and Zr) containing Ta and Cu in the Ag, as an optical information recording medium excellent in the reflective characteristic and the write-once and rewriting characteristic, and also capable of effectively detecting and excluding an illegally duplicated copy (Japanese Patent Application No. 2006-166311). Hereinafter, this invention is referred to as the prior invention.

The present inventor has particularly investigated a process for manufacturing an Ag-Ta-Cu alloy sputtering target, which is aimed at forming an Ag-Ta-Cu alloy thin film (in the case where X is Ta), by the sputtering process, since application of the prior invention. Herein, the melting point of Ta is 2977°C which is extremely higher in comparison with those of Ag (melting point: 961°C) and Cu (melting point: 1083.4°C), therefore if an Ag-Ta-Cu alloy target is manufactured by the melting and casting process in the same way as with a conventional Ag base alloy target, variation and segregation in each element becomes larger, because Ta having a higher melting point, and Ag and Cu having lower melting points than that of Ta, do not melt uniformly together. Accordingly, an Ag-Ta-Cu alloy sputtering target by which a thin film excellent in the uniformity in composition can be formed in a steady stable condition, cannot be manufactured by a conventional process.

Thus, the inventor has been developing the investigation focusing on the powder sintering process which has been recommended in the aforementioned Patent Documents 12 and 13, in order to provide an Ag-Ta-Cu alloy target in which Ta particles and Cu particles having certain particle sizes are well dispersed and well distributed in the Ag matrix. In particular, an alloy composition of the present invention has a wide range of sputtering yield of each element constituting the target (the sputtering yields are 3.40 for Ag, 0.62 for Ta, and 2.30 for Cu), and especially, the difference between Ta and Ag or Ta and Cu is quite large. In such a target that contains elements having very different sputtering yield, when there is a variation or a segregation of elements in the target surface even if it is small, a thin film obtained with the use of the target is adversely affected in the uniformity of composition, with the result that a thin film of high quality can not be obtained. Therefore, an Ag-Ta-Cu alloy target is required to have a remarkably higher characteristic compared with other targets, and it is needed that an inherent manufacturing method suitable for the target is to be established.

In consideration of these circumstances, the present inventor has developed the study from the viewpoint of providing a manufacturing method suitable for an Ag-Ta-Cu alloy target . As a result, the inventor has found that:
(a) in a powder sintering process, an intended purpose can be realized by controlling appropriately a material powder mixing process and the HIP processing which is a pressure sintering process; and
(b) an Ag-Ta-Cu alloy target thus obtained never has a variation or a segregation of Ta particles or Cu particles, allowing the thin film obtained by the target to be extremely useful as a reflective film for an optical information recording medium. The present invention has been completed based on the finding.

The present invention is thus different from the techniques of the above Patent Documents 12 and 13 in the point that the present invention is specialized in an Ag-Ta-Cu alloy. In those Patent Documents, it is only described that a Ta target or a process for manufacturing a Ta containing target by the powder sintering process can be recommended, without any detailed specification about an alloy composition target aimed by the present invention. That is, those Patent Documents teach nothing about how to manufacture a target containing Ta and Cu in an Ag base alloy. In addition, those Patent Documents disclose nothing about a powder mixing process and the HIP processing, by which the present invention is characterized.

The Ag-Ta-Cu alloy target according to the present invention will be described in detail below.

The target of the present invention is a sputtering target made of an Ag base alloy containing 0. 6 to 10.5 atomic % Ta, 2 to 13 atomic % Cu. When performing an image analysis on the sputtering surface of the sputtering target, the target satisfies the following two requirements:
(1) regarding Ta, (i) the ratio of the total area of Ta particles having a circle equivalent diameter of from 10 µm or more to 50 µm or less, to the total area of all Ta particles, is 60 % or more, and (ii) the average distance between the centers of gravity of Ta particles is from 10 µn or more to 50 µm or less;
(2) regarding Cu, (i) the ratio of the total area of Cu particles having a circle equivalent diameter of from 10 µm or more to 50 µm or less, to the total area of all Cu particles, is 70% or more, and (ii) the average distance between the centers of gravity of Cu particles is from 60 µm or more to 120 µm or less.

For-explanation purposes, the total area of Ta particles having a circle equivalent diameter of from 10 µm or more to 50 µm or less, to the total area of all Ta particles, is sometimes referred to as the "ratio of area of Ta particle." Similarly, the total area of Cu particles having a circle equivalent diameter of from 10 µm or more to 50 µm or less, to the total area of all the Cu particles, is sometimes referred to as the "ratio of area of Cu particle."

The Ag-Ta-Cu alloy to be realized by the present invention will be described at first.

Among Ag-X-Cu alloys (X=Ti, W, Ta, V, Mo, Nb, and Zr) described in the above prior invention, an Ag-Ta-Cu alloy, an alloy when X is Ta, particularly draws attention because a thin film of the alloy is excellent in the reflective characteristic and the write-once and rewriting characteristic. That is the reason why the present invention pays attention thereto.

The content of Ta contained in the Ag base alloy target of the present invention falls in the range of from 0.6 atomic % or more to 10.5 atomic % or less, in the same way as that of the Ag base alloy reflective film of the prior invention. That is, the content of Ta used in the target of the present invention is specified by the relation with the thin film, thereby specifying the content of Ta required for obtaining an Ag base alloy reflective film for a high-quality optical disk (from 0. 6 atomic % or more to 10.5 atomic % or less) by the Ag base alloy target. When the minimum content of Ta contained in an Ag base alloy target is below 0.6 atomic %, the content of Ta in an Ag base alloy reflective film is also below 0.6 atomic %, with the consequent result that a desired Ag base alloy thin film excellent in the write-once recording characteristic is not obtained. On the other hand, when the maximum content of Ta contained in an Ag base alloy target is beyond 10.5 atomic %, the content of Ta in an Ag base alloy reflective film is also beyond 10.5 atomic %, with the result that a desired Ag base alloy thin film excellent in the reflective characteristic can not be obtained. The content of Ta is preferably from 1 atomic % or more to 8 atomic % or less, more preferably from 2 atomic % or more to 6 atomic % or less.

In addition, the content of Cu contained in the Ag base alloy target of the present invention falls in the range of from 2 atomic % or more to 13 atomic % or less, in the same way as that of the Ag base alloy reflective film of the prior invention. That is, the content of Cu used in the target of the present invention is specified by the relation with the thin film, in the same way as previously specifying the content of the Ta, thereby specifying the content of Cu required for obtaining an Ag base alloy reflective film for a high-quality optical disk (from 2 atomic % or more to 13 atomic % or less) by the Ag base alloy target. When the minimum content of Cu contained in an Ag base alloy target is below 2 atomic %, the content of Cu in an Ag base alloy reflective film is also below 2 atomic %, with consequent result that a desired Ag base alloy thin film excellent in the write-once recording characteristic is not obtained. On the other hand, when the maximum content of Cu contained in an Ag base alloy target is beyond 13 atomic %, the content of Cu in an Ag base alloy reflective film is also beyond 13 atomic %, with the result that a desired Ag base alloy thin film excellent in the reflective characteristic can not be obtained. The content of Cu is preferably from 2.5 atomic % or more to 10 atomic % or less, more preferably from 3 atomic % or more to 8 atomic % or less.

As mentioned above, the Ag base alloy used for the present invention contains both Ta and Cu, and the remainder are Ag and inevitable impurities. Examples of the inevitable impurities include, for example, elements which enter during manufacturing processes or the like, such as Si, Fe, C, O, N, etc.

Further, the Ag-Ta-Cu alloy target of the present invention is required that Ta and Cu, which are located in the sputtering surface (in the direction of the surface), satisfy the following two requirements (1) and (2), respectively.

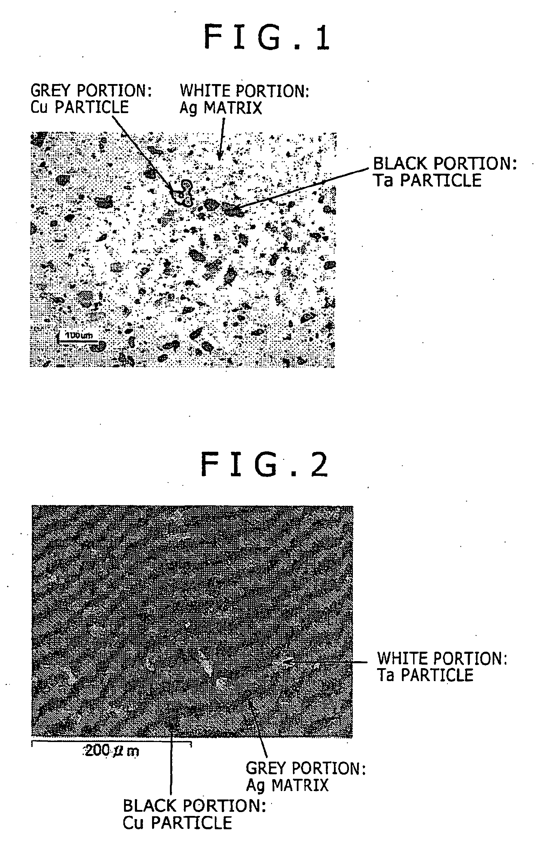

That is, when observing the surface to be measured of the Ag base alloy target according to the present invention using a measuring method later described in detail, neither of Ta or Cu is located as an intermetallic compound and each of the two is dispersed in the Ag matrix as independent Ta particles or Cu particles (see Figs. 1 and 2 later described.) And it has been found that, when controlling each of the Ta particles and the Cu particles in the way as the aforementioned (i) and (ii), a high-quality thin film can be formed, as shown in the table of the example later described.

With respect to each of the Ta particles and the Cu particles, the ratios of area of the Ta particles and the Cu particles having their circle equivalent diameters in a predetermined range are controlled so as to be beyond a. predetermined number, respectively.

However, in order to form thin films of high quality with high performance in a steady stable condition, it is insufficient only to control the ratios of area of the Ta particles and the Cu particles as the above (i). It has been found that (ii) the average distance between the centers of gravity of particles (in short, the average distance between adjacent particles) is also required to be controlled appropriately such that Ta particles and Cu particles having a predetermined circular equivalent diameter, are distributed uniformly at almost the same intervals (see examples later described). According to the results of the study made by the present inventor, it has been known that an aggregation part by adjacent Ta particles or Cu particles adversely affects a segregation and a variation in the sputtering surface, therefore a thin film cannot ensure the uniformity of the compositions in the film surface, even when Ta particles and Cu particles keep the ratios of area specified by the present invention, with the particles aggregated together. It has been known that a segregation and a variation can be conversely suppressed when adj acent Ta articles or Cu particles are distant from each other at a predetermined average distance between the centers of gravity, even when the ratios of area of Ta particles and Cu particles are equal.

Ta and Cu will be respectively described in detail below.

### (1) Regarding Ta

Ta satisfies the above requirement (1), that is: (i) the ratio of the total area of the Ta particles having a circle equivalent diameter of from 10 to 50 µm, to the total area of all Ta particles, is 60 % or more; and (ii) an average distance between the centers of gravity is from 10 to 50 µm. As fully examined in the example later described, when at least one of the above two requirements (i) (ii) is not satisfied, a variation and a segregation of Ta particles are increased.

As specified in detail by the above (i), it is needed that the ratio of the total area of the Ta particles having a circle equivalent diameter of from 10 to 50 µm, to the total area of all Ta particles, is 60 % or more. It is possible that a Ta particle having a circle equivalent diameter below 10 µm becomes a starting point of pluck at the time of machining executed in the final process after the powder sintering process, and the pluck becomes a starting point of abnormal discharge at the time of sputtering film formation. On the other hand, a Ta particle having a circle equivalent diameter beyond 50 µm becomes a cause of a segregation in the sputtering surface, causing a deteriorated uniformity of Ta in the film surface of the Ag-Ta-Cu alloy thin film obtained by the sputtering process. The circle equivalent diameter of Ta particles is preferably in the range of from about 20 µm or more to about 40 µm or less.

In the present invention, the ratio of area of Ta particles of which circle equivalent diameter is in the above range is specified to be 60 % or more. When the ratio of area of Ta particles mentioned above is less than 60 %, the particle sizes of Ta particles varies, causing a deteriorated uniformity of Ta in the film surface of the Ag-Ta-Cu alloy thin film. The higher the above ratio of area of Ta particles, the better, for example, the ratio of area of Ta particles is preferably to be 70 % or more.

Further in the present invention, the average distance between the centers of gravity of Ta particles should be in the range of from 10 to 50 µm, as specified by the above (ii). This means that the adjacent Ta particles are distributed uniformly at the intervals of from about 10 to about 50 µm (uniform distribution). When the average distance between the centers of gravity of the adjacent Ta particles is below 10 µm or beyond 50 µm, the Ta particles are in the state of segregation, causing a deteriorated uniformity of Ta in the film surface of the Ag-Ta-Cu alloy thin film. The average distance between the centers of gravity of Ta particles is preferably in the range of from about 20 µm or more to about 40 µm or less.

### (2) Regarding Cu

Cu satisfies the above requirement (2), that is: (i) the ratio of the total area of the Cu particles having a circle equivalent diameter of from 10 to 50 µm, to the total area of all Ta particles, is 70 % or more; and (ii) an average distance between the centers of gravity is from 60 to 120 µm. As fully examined in example later described, when at least one of the above two requirements (i)(ii) is not satisfied, a variation and a segregation of Cu particles are increased.

As specified in detail by the above (i), it is needed that the ratio of the total area of the Cu particles having a circle equivalent diameter of from 10 to 50 µm, to the total area of all Cu particles, is 70 % or more. It is possible that a Cu particle having a circle equivalent diameter below 10 µm becomes a starting point of pluck at the time of machining executed in the final process after the powder sintering process, and the pluck becomes a starting point of abnormal discharge at the time of sputtering film formation. On the other hand, a Cu particle having a circle equivalent diameter beyond 50 µm becomes a cause of a segregation in the sputtering surface, causing a deteriorated uniformity of Cu in the film surface of the Ag-Ta-Cu alloy thin film obtained by the sputtering process. The circle equivalent diameter of Cu particles is preferably in the range of from about 20 µm or more to about 40 µm or less.

In the present invention, the ratio of area of Cu particles of which circle equivalent diameter is in the above range is specified to be 70 % or more. When the ratio of area of Cu particles mentioned above is less than 70 %, the particle sizes of Cu particles varies, causing a deteriorated uniformity of Cu in the film surface of the Ag-Ta-Cu alloy thin film. The higher the above ratio of area of Cu particles, the better, for example, the ratio of area of Cu particles is preferably to be 80 % or more.

Further in the present invention, the average distance between the centers of gravity of Cu particles should be in the range of from 60 to 120 µm, as specified by the above (ii) . This means that the adjacent Cu particles are distributed uniformly at the intervals of from 60 to 120 µm (uniform distribution) . When the average distance between the centers of gravity of the adjacent Cu particles is below 60 µm or beyond 120 µm, the Cu particles are in the state of segregation, causing a deteriorated uniformity of Cu in the film surface of the Ag-Ta-Cu alloy thin film. The average distance between the centers of gravity of Cu particles is preferably in the range of from about 70 µm or more to about 110 µm or less.

The above requirements (1) and (2) are measured as follows:

An Ag base alloy target containing Ta and Cu (after being given a machined finish) is prepared. The process for manufacturing the above Ag base alloy target is described in detail later.

(a)Microscopic observation or (b)area analysis using an x-ray microanalysis (EPMA: Electron Probe Micro Analysis) is carried out on the measured surface of the target to obtain an image which is subsequently image-analyzed. Herein, "the measured surface of the target" refers to a sputtering surface which has been given a machined finish as described above and then polished using wet polishing or the like as necessary. By carrying out wet polishing on the surface, microscopic observation or area analysis using an x-ray microanalysis are readily performed.

As described above, an image is acquired by the two ways: (a) microscopic observation; or (b) area analysis using an x-ray microanalysis. In the microscopic observation of the above-mentioned (a), either of an optical microscope or a Scanning Electron Microscope (SEM) may be used. When an image is acquired by the microscopic observation as the above (a), Ta particles and Cu particles should be distinguished and classified by using an image analyzer in accordance with the brightness of the image. On the other hand, when an image is acquired by the area analysis using an x-ray microanalysis as the above (b), there is an advantage that Ta particles and Cu particles can be distinguished and classified by the area analysis using an x-ray microanalysis.
In example described later, images have been acquired by the above (b).

A way of acquiring an image by the above (a) microscopic observation will be described in detail below. At first, the metal structure of the Ag-Ta-Cu alloy target is observed using an optical microscope or an SEM and photographed (magnification: 100 to 400 times). The magnification is suitably determined at an appropriate state in accordance with the sizes or the dispersion state, or the like, of Ta particles and Cu particles in the Ag matrix. For reference, an optical microscopic image (magnification: 100 times) of sample No. 4 (an example of the present invention, which satisfies the requirements of the present invention) of the examples described later is shown in Fig.1; and an SEM image (magnification: 300 times) of the same is shown in Fig.2. As shown in Figs.1 and 2, Ag, Ta, and Cu constituting the target are observed in these microscopic images as independent Ta particles and Cu particles in the Ag matrix, not as intermetallic compounds.

On the other hand, when acquiring an image by the above (b) area analysis using an x-ray microanalysis, area analysis by an x-ray microanalysis is performed on the Ag-Ta-Cu alloy target and a characteristic X-ray image of each element is taken (magnification: 100 to 400 times). Thereby, the distribution state of each element constituting the target becomes known. The magnification is suitably determined at an appropriate state in accordance with the sizes or the dispersion state, or the like, of Ta particles and Cu particles in the Ag matrix.

The x-ray microanalysis is carried out under the conditions as follows:
a) Pretreatment of a specimen
   The specimen was embedded into resin and the analysis surface was wet-polished.
b) Analysis device
   INCA Energy+ "EDX micro-analyzer" (made by OXFORD Instruments)
c) Analysis conditions
   Accelerating voltage: 7kV
   Probe current: 1.6nA
   Time: 2ms
   Marks: 1024x768
   Interval: X= 0.4 µm, Y= 0.4 µm

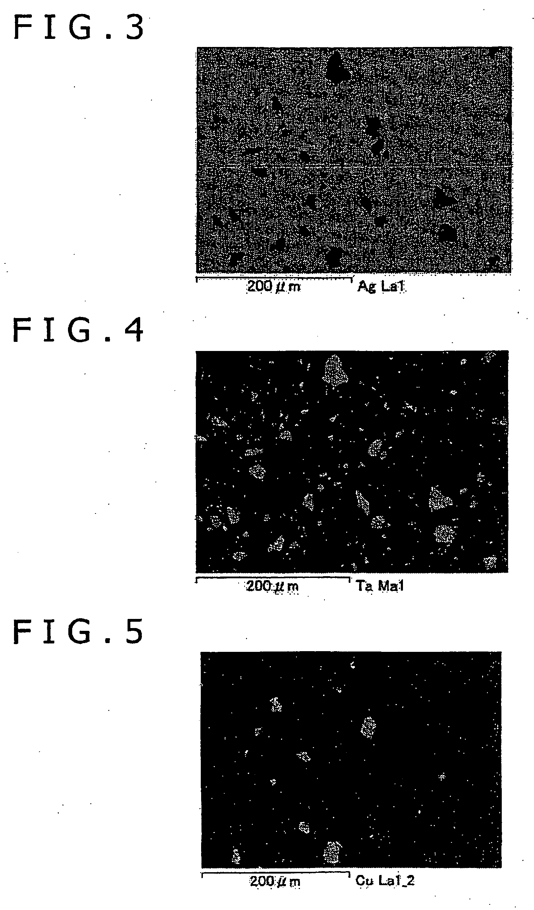

For reference, a characteristic X-ray image of the EPMA area analysis (magnification: 300 times), which shows the distribution state of Ag in the above sample No. 4, is shown in Fig. 3; a characteristic X-ray image of the EPMA area analysis (magnification: 300 times), which shows the distribution state of Ta, is shown in Fig.4; and a characteristic X-ray image of the EPMA area analysis (magnification: 300 times), which shows the distribution state of Cu, is shown Fig.5, respectively. Herein, each of La1 in Fig.3, Mal in Fig.4, and La1 and 2 in Fig.5 represents characteristic X-rays of each element.

Subsequently, image analysis of the image obtained by the above ways (a) or (b) was carried out. The image analysis was carried out by using an image analyzer: NanoHunter NS2K-Pro (made by NANO System Corp.) All Ta particles observed in the Ag matrix were measured with respect to: their circle equivalent diameters; the total area (X) of all the Ta particles; and the total area (Y) of all the Ta particles having a circular equivalent diameter of from 10 µm to 50 µm, and the ratio of X/Y was set as the "ratio of area of Ta particle." In addition, Cu was also measured in the same way as described above such that the circular equivalent diameter and the ratio of area of Cu particles were calculated.

Further, the average distances between the centers of gravity (average value of the distances between the centers of gravity) of each of all Ta particles and all Cu particles observable in the visual field, were calculated, respectively.

"The distance between the centers of gravity" used herein means the length of the straight line connecting the centers of gravity of the images of the adj acent two Ta particles or Cu particles, in accordance with the following rules (a) and (b) .

### (a) A line connecting two images should not pass on another image.

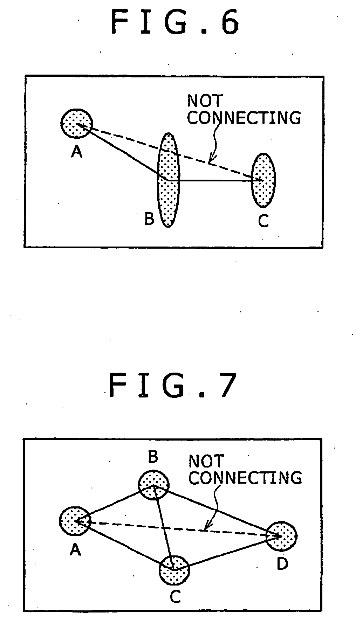

For example, when pictures of A, B, and C are located as shown in Fig.6, the lengths of the two lines connecting the center of gravity of A and the center of gravity of B, and the center of gravity of B and the center of gravity of C, are "the distances between the centers of gravity." However, the line connecting the center of gravity of A and the center of gravity of C should not be "the distance between the centers of gravity", because the line passes on B.

### (b) When two lines connecting images cross each other, the shorter line should remain.

For example, when images of A, B, C, and D are located as shown in Fig.7, the lengths of the five lines connecting: the center of gravity of A and the center of gravity of B; the center of gravity of A and the center of gravity of C; the center of gravity of B and the center of gravity of C; the center of gravity of B and the center of gravity of D; and the center of gravity of C and the center of gravity of D, are "the distances between the centers of gravity." However, the line connecting the center of gravity of A and the center of gravity of D should not be "the distance between the centers of gravity", because the line crosses the line connecting the center of gravity B and the center of gravity C, and the former line is longer than the latter line.

In the present invention, the distances between the centers of gravity with respect to all Ta particles and Cu particles having their areas of 1 µm ² or more, which were observed in the above characteristic X-ray images, were measured such that the average values thereof were set as the distances between the centers of gravity of Ta particle and Cu particle, respectively.

Because the above image analyzer used in the present invention is provided with the programs by which the aforementioned circle equivalent diameter, the ratio of area, and the distance between the centers of gravity are automatically calculated, these numbers are automatically calculated.

The thickness of the Ag base alloy target is not particularly limited, and is preferably in the range of from about 1 to about 50 mm so that a target suitable for formation of a desired reflective thin film (thickness of the film: 2 to 500 nm) for an optical disk, can be obtained.

A process for manufacturing a sputtering target according to the present invention will be described below.

The manufacturing method according to the present invention is **characterized in that** the process includes: mixing a material containing Ag powder having the mean volume diameter (d50) of from 10 µm or more to 50 µm or less, Ta powder having the mean volume diameter (d50) of from 10 µm or more to 50 µm or less, and Cu powder having the mean volume diameter (d50) of from 10 µm or more to 50 µm or less, for 30 to 90 minutes to prepare for a mixed power; and carrying out the HIP processing on the mixed powder at the temperature of 500 to 600 °C for 1 to 3 hours.

That is, the Ag base alloy target according to the present invention is manufactured by the powder sintering process, not by the melting and casting process, as described before, and in particular, the powder mixing process and the HIP processing should be paid attention to. As shown in example described later, a target in which the particle sizes and the distribution state of the Ta particles and the Cu particles in the Ag matrix are uniform, cannot be obtained when being manufactured by a process where at least one of the conditions is not satisfied, with the result that a high quality thin film excellent in the uniformity of composition in the film surface can not be obtained.

Each process by which the manufacturing method according to the present invention is characterized will be described below.

### (Powder mixing process)

Ag powder, Ta powder, and Cu powder having their mean volume diameter (d50) of from 10 µm or more to 50 µm or less, are at first prepared as material powders. According to the present invention, it is required to use powder having a uniform particle size distribution, as a material, thereby the materials can be mixed uniformly, with segregation at the time of mixing being prevented. When using powder having the mean volume diameter (d50) of below 10 µm, aggregation or oxidization are apt to occur during mixing. On the other hand, when using powder having the mean volume diameter (d50) of beyond 50 µm, the fluidity of the powder becomes better, increasing the possibility of segregation. Each mean volume diameter (d50) of the material powers is preferably in the range of 15 µm or more to 45 µm or less.

Herein, "the mean volume diameter (d50)" refers to the diameter of the particles which are located at point where the accumulated volume percentage reaches 50 %, assuming that the total volume of the powder is 100 % and the relation curve between the particle diameters of the powder and the accumulated volume percentage is found by a sieve process. In examples described later, the particle distribution was searched for by using a laser diffraction, scattering, particle size distribution analyzer(Microtrac Particle Size Distribution Analyzer: made by NIKKISO CO., LTD.)

The material containing each of above-mentioned powder is mixed for 30 to 90 minutes. When the material is mixed for a short time of under 30 minutes, each powder cannot be mixed uniformly with each other, with the result that the ratios of area and the average distances between the centers of gravity of the Ta particles or the Cu particles in the Ag matrix, do not satisfy the requirements of the present invention. On the other hand, when the material is mixed for a long time of over 90 minutes, the material powder once mixed uniformly is in the state of separation, with the result that the requirement of the invention is not satisfied. Therefore, the material is preferably mixed for the time of from 40 minutes or more to 70 minutes or less.

### (HIP processing)

The mixed powder thus obtained is subsequently subjected to the HIP processing. In the present invention, the mixed powder is subjected to the HIP processing at the temperature of 500 to 600 °C for 1 to 3 hours.

When the temperature of the HIP processing is below 500 °C, or the time of the HIP processing is under 1 hour, sintering is insufficient, with the result that the ratios of area and the average distances between the centers of gravity of the Ta particles or the Cu particles in the Ag matrix, do not satisfy the requirements of the present invention. On the other hand, when the temperature of the HIP processing is beyond 600 °C, or the time of the HIP processing is over 3 hours, with the result that the requirements of the present invention is not satisfied. In addition, it is possible that an alloy phase is generated in the interfaces between the Ag matrix and the Ta particle or the Ag matrix and the Cu particle, therefore an abnormal discharge, such as arcing, occurs starting from the alloy phase during sputtering film formation, with the result that a thin film can not be formed. The HIP processing is preferably carried out at the temperature of from 520 °C or higher to 580 °C or lower. The HIP processing is preferably carried out for 1.5 hours or more to 2.5 hours or less.

After being subjected to the HIP processing, a desired target can be obtained by being machined into a predetermined shape (lathe, milling machine processing, etc.) The shape and the size of a target are not particularly limited, and various known shapes and sizes can be adopted. In particular, a disk-shaped target is preferable for formation of a reflective film for an optical disk.

A process for forming an Ag base alloy thin film using the Ag base alloy target according to the present invention, is not particularly limited, and sputtering methods commonly used, for example, DC sputtering process, RF sputtering process, magnetron sputtering process, and reactive sputtering process, or the like, can be adopted.

### Examples

The present invention will be described in more detail with reference to example; however, the invention should not be limited to the following example, and can be practiced with appropriate modifications added thereto as far as those modifications comply with the spirit of the present invention, and any of those modifications should fall in the scope of the present invention.

### (1)Manufacturing an Ag-Ta-Cu alloy sputtering target

A disk-shaped Ag-Ta-Cu alloy sputtering target was manufactured according to the following procedure (powder mixture → encapsulation → capsule deaeration ->HIP-> capsule removal → milling → round slice cutting → machining).

As shown in Table 1, predetermined amounts of Ag powder, Ta powder, and Cu powder having their mean volume diameter d50 of about 30 µm, were added in a mixer to be mixed for various time of from 20 minutes to 110 minutes.

The above mixed powder was then filled into a cylindrical capsule to be heated and maintained at 400°C for 9 hours. Subsequently, the capsule was deaerated so that the inside thereof was in a vacuum state.

The deaerated capsule was then subjected to the HIP processing. Specifically, the HIP processing was carried out under various conditions: the temperature of from 400 to 700°C; and the HIP processing time of from 0.5 to 5 hours.

After the HIP processing, the capsule was removed and the cylindrical Ag-Ta-Cu alloy material was taken out. After milling the surface of the above Ag-Ta-Cu alloy material, the material was cut into round slices such that disk-shaped Ag-Ta-Cu alloy materials were obtained.

The disk-shaped Ag-Ta-Cu alloy material thus obtained was machined (lathe processing), and the Ag-Ta-Cu alloy sputtering target having a diameter of 101. 6 mm and a thickness of 5 mm, was finished.

### (2) Area analysis using an x-ray microanalysis and image analysis of the Ag-Ta-Cu alloy sputtering target

An image acquired by the aforementioned (b) area analysis using an x-ray microanalysis, with the use of the disk-shaped Ag-Ta-Cu alloy sputtering target thus obtained, was carried out. In detail, the characteristic X-ray images of Ta particle and Cu particle, which are acquired by the EPMA area analysis result (magnification: 300 times), were image-analyzed in accordance with the aforementioned way such that circle equivalent diameters, ratios of area, and average distances between the centers of gravity were measured.

### (3) Formation of an Ag-Ta-Cu alloy thin film, and evaluation of the uniformity of composition in the film surface

An Ag-Ta-Cu alloy thin film having its thickness of 100 nm was formed on a glass substrate (diameter: 50.8 mm, thickness: 0.7 mm) by the DC magnetron sputtering method with the use of the Ag-Ta-Cu alloy sputtering target thus obtained. Sputtering conditions are as follows: ultimate-vacuum: 0.27x10-3 Pa or less, Ar gas pressure: 0.27 Pa, sputtering power: 200 W, distance between the substrate and the target (anode-cathode distance):55 mm and temperature of substrate: room temperature. Before performing the above DC magnetron sputtering, pre-sputtering was fully carried out in advance such that the influence by the surface layer of the Ag-Ta-Cu alloy sputtering target could be prevented from appearing.

X-ray microanalysis (EPMA) was subsequently performed, in order to examine the variation in composition in the film surface of the Ag-Ta-Cu alloy thin film thus obtained. The specific conditions of the x-ray microanalysis are the same as that of the above analysis of the target surface to be measured. Five measurement points were selected within the thin film surface (diameter :50.8 mm), which are appropriate five points (total 5 points on any diameter: 10 mm to right from the center, 20 mm to right, 10 mm to left, 20 mm to left, and the center.) The amounts of Ta and Cu at each measurement point were calculated then the minimum and the maximum contents of Ta, and the minimum and the maximum contents of Cu were found, respectively. Herein, when all of the ratios of the minimum contents to the maximum contents of Ta and Cu are 0.90 or more in an Ag-Ta-Cu alloy thin film, the film is determined to be successful (Good), that is, the film is determined to be excellent in "the uniformity of composition in the thin film surface. On the other hand, when any one of the ratios of the minimum contents to the maximum contents of Ta and Cu is below 0.90, the thin film is determined to be unsuccessful (NG), that is, the thin film is determined to be "inferior in the uniformity of composition in the thin film surface."

These results are also shown in Table 1.

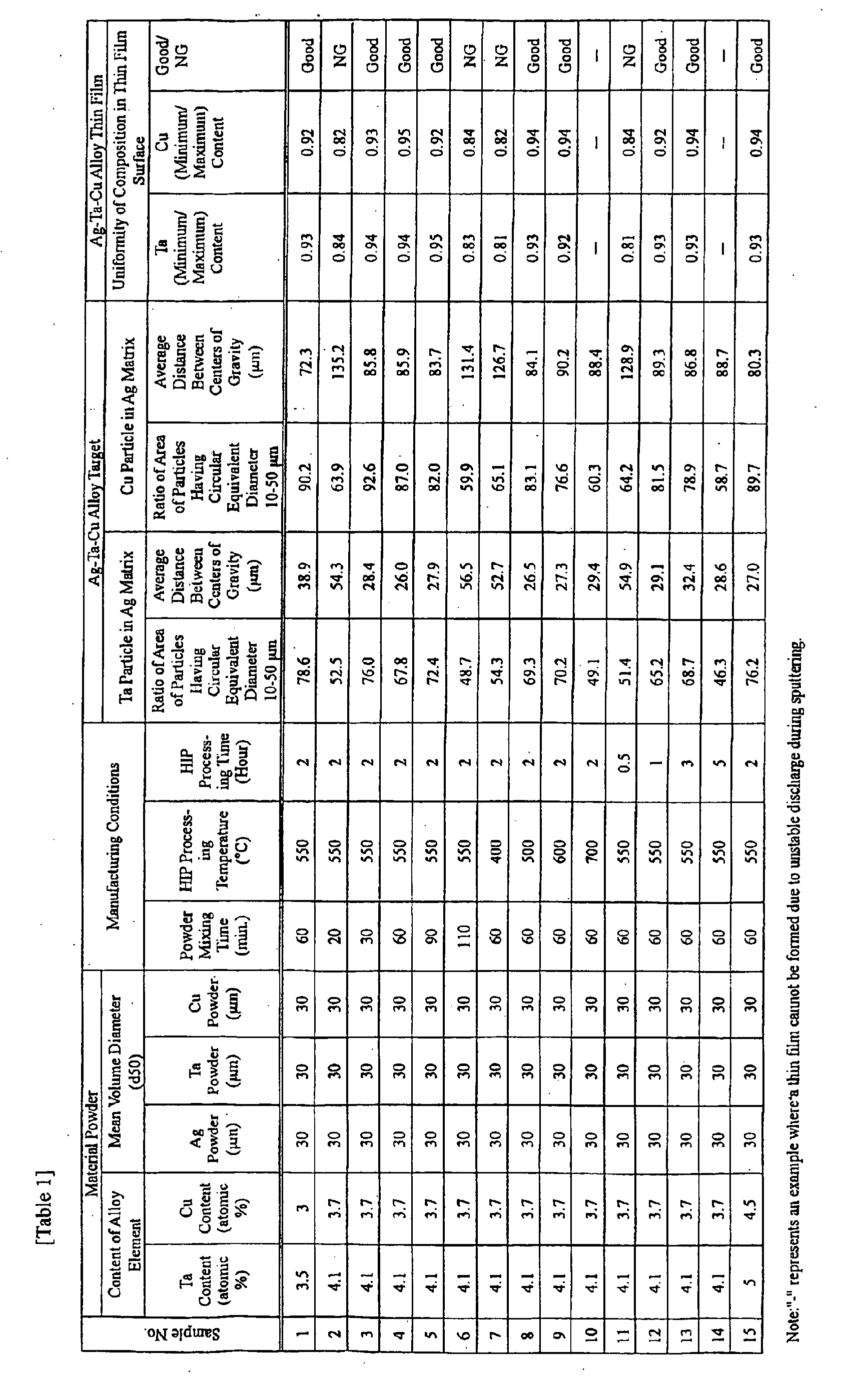

The following considerations can be made from Table 1.

Samples No. 1, 3-5, 8-9, 12-13 and 15 were all excellent in the uniformity of composition in the thin film surface, because their films were all formed by using an Ag base alloy target of which the particle sizes and the distribution states of Ta particles and Cu particles in the Ag matrix, satisfy the requirements of the present invention.

on the other hand, the thin film formed by the following Ag base alloy target of which the particle sizes and the distribution states of Ta particles and Cu particles in the Ag matrix, do not satisfy the requirements of the present invention, could not acquire the good uniformity of composition in the thin film surface.

First, since Ta particles and Cu particles are not mixed uniformly enough, as for the target of sample No. 2 which powder mixture time manufactured on short conditions with 20 minutes, the ratio of area and average distance between the centers of gravity of Ta particles and Cu particles which constitute a target have separated from the range of a the present invention.

On the other hand, sample No. 6, which were manufactured under the condition in which the powder were mixed for a long time, 110 minutes, could not uniformly control the particle sizes and the distribution states of Ta particles and Cu particles in the target, because the uniformly mixed powder was in the state of separation.

Sample No. 7, which is an example where the HIP processing was carried out at a low temperature of 400 °C, and sample No. 11, which is an example where the HIP processing was carried out for a short time of 0.5 hour, were both insufficient in sintering, therefore the particle sizes and the distribution states of Ta particles and Cu particles in the target could not be controlled uniformly.

On the other hand, sample No. 10, which is an example where the HIP processing was carried out at a high temperature of 700°C, sample No. 14, which is an example where the HIP processing was carried out for a long time of 5 hours, both could not uniformly disperse and control the Ta particles and Cu particles in the target. Further, discharge during formation of the thin film on the samples No. 10 and 14 was not stable, with the result that an Ag base alloy thin film could not be formed.

## Claims

1. A sputtering target made of an Ag base alloy comprising 0.6 to 10.5 atomic % Ta and 2 to 13 atomic % Cu, wherein, when the sputtering surface of the sputtering target is image-analyzed,
(1) regarding Ta, the ratio of the total area of Ta particles having a circle equivalent diameter of from 10 µm or more to 50 µm or less, to the total area of all Ta particles, is 60 % or more, and the average distance between the centers of gravity of Ta particles is from 10 µm or more to 50 µm or less; and
(2) regarding Cu, the ratio of the total area of Cu particles having a circle equivalent diameter of from 10 µm or more to 50 µm or less, to the total area of all Cu particles, is 70 % or more, and the average distance between the centers of gravity is from 60 µm or more to 120 µm or less.

2. Use of the Ag base alloy sputtering target according to claim 1,
for forming a reflective film for an optical information recording medium.

3. A method for manufacturing the Ag base alloy sputtering target according to claim 1, comprising:
mixing a material containing Ag powder having the mean volume diameter (d50) of from 10 µm or more to 50 µm or less, Ta powder having the mean volume diameter (d50) of from 10 µm or more to 50 µm or less, and Cu powder having the mean volume diameter (d50) of from 10 µm or more to 50 µm or less, for 30 to 90 minutes to prepare for a mixed power; and
carrying out the Hot Isostatic Pressing processing on the mixed powder at the temperature of 500 to 600 °C for 1 to 3 hours.

## Patentansprüche

1. Sputtertarget aus einer Ag-Basislegierung, umfassend 0,6 bis 10,5 Atom-% Ta und 2 bis 13 Atom-% Cu, wobei, wenn die Sputteroberfläche des Sputtertargets bildanalysiert wird,
(1) bezüglich Ta das Verhältnis des Gesamtbereichs von Ta-Teilchen mit einem Kreis-Äquivalentdurchmesser von 10 µm oder mehr bis 50 µm oder weniger zu dem Gesamtbereich sämtlicher Ta-Teilchen 60 % oder mehr beträgt und der durchschnittliche Abstand zwischen den Schwerkraftzentren der Ta-Teilchen von 10 µm oder mehr bis 50 µm oder weniger beträgt, und
(2) bezüglich Cu das Verhältnis des Gesamtbereichs an Cu-Teilchen mit einem Kreis-Äquivalentdurchmesser von 10 µm oder mehr bis 50 µm oder weniger zu dem Gesamtbereich sämtlicher Cu-Teilchen 70% oder mehr beträgt und der durchschnittliche Abstand zwischen den Schwerkraftszentren von 60 µm oder mehr bis 120 µm oder weniger beträgt.

2. Verwendung des Ag-Basislegierung-Sputtertargets gemäß Anspruch 1 zum Bilden eines Reflexionsfilms für ein optisches Informationsaufzeichnungsmedium.

3. Verfahren zur Herstellung des Ag-Basislegierung-Sputtertargets gemäß Anspruch 1, umfassend:
das Mischen eines Materials, enthaltend Ag-Pulver mit dem mittleren Volumendurchmesser (d50) von 10 µm oder mehr bis 50 µm oder weniger, Ta-Pulver mit dem mittleren Volumendurchmesser (d50) von 10 µm oder mehr bis 50 µm oder weniger und Cu-Pulver mit dem mittleren Volumendurchmesser (d50) von 10 µm oder mehr bis 50 µm oder weniger, für 30 bis 90 Minuten zur Herstellung eines Pulvergemisches, und
das Durchführen des Verarbeitens mittels heißisostatischem Pressen des Pulvergemisches bei der Temperatur von 500 bis 600°C für 1 bis 3 Stunden.

## Revendications

1. Cible de pulvérisation d'alliage à base d'Ag comprenant de 0,6 à 10,5 % atomique de Ta et de 2 à 13 % atomique de Cu, dans lequel, lorsque la surface de pulvérisation de la cible de pulvérisation est analysée sur image,
(1) concernant le Ta, le rapport de la surface totale de particules de Ta ayant un diamètre équivalent de cercle de 10 µm minimum à 50 µm maximum, sur la surface totale de l'ensemble des particules de Ta est supérieur ou égal à 60 %, et la distance moyenne entre les centres de gravité des particules de Ta va de 10 µm minimum à 50 µm maximum ; et
(2) concernant le Cu, le rapport de la surface totale de particules de Cu ayant un diamètre équivalent de cercle de 10 µm minimum à 50 µm maximum, sur la surface totale de l'ensemble des particules de Cu est supérieur ou égal à 70 %, et la distance moyenne entre les centres de gravité va de 60 µm minimum à 120 µm maximum.

2. Utilisation de la cible de pulvérisation d'alliage à base d'Ag selon la revendication 1, pour former un film réfléchissant pour un support d'enregistrement d'informations optique.

3. Procédé de fabrication de la cible de pulvérisation d'alliage à base d'Ag selon la revendication 1, consistant à :
mélanger un matériau contenant de la poudre d'Ag ayant le diamètre en volume moyen (d50) de 10 µm minimum à 50 µm maximum, la poudre de Ta ayant le diamètre en volume moyen (d50) de 10 µm minimum à 50 µm maximum et la poudre de Cu ayant le diamètre en volume moyen (d50) de 10 µm minimum à 50 µm maximum pendant 30 à 90 minutes pour préparer une poudre mixte ; et
procéder au traitement de pressage isostatique à chaud sur la poudre mixte à la température de 500 à 600°C pendant 1 à 3 heures.
